# EUROPEAN PATENT APPLICATION

(11) **EP 4 836 670 A1**
(43) Date of publication of application: **04.11.2026**
(21) Application number: 25223674.0
(22) Date of filing: 16.12.2025
(51) Int. Cl.: H10W 42/20, H10W 90/10, H10W 90/20, H10W 90/00, H10W 42/40

(54) **SHIELDING DIES FOR PROTECTION OF INTEGRATED CIRCUIT DIES IN MULTI-DIE PACKAGES**

(30) Priority: 30.04.2025 US 202519195163
(71) Applicant: Intel Corporation, Santa Clara, CA 95054 (US)
(72) Inventor: ELBAUM, Reuven, 3292207 Haifa (IL); PEER, Elad, 2067708 Yokneam Illit (IL); BEAR, Uri, 3702166 Pardes-Hana (IL); SIDOROV, Elena, 3271409 Haifa (IL)
(74) Representative: 2SPL Patentanwälte PartG mbB

(57) **Abstract**

Embodiments of the present disclosure include multi-die packages incorporating shielding dies that cover packaged dies and inter-die connectivity signals. The shielding die is electrically conductively coupled to the packaged dies, and certain functionality of the packaged dies is to be disabled in response to the shielding die being tampered with or removed, preventing access to confidential or otherwise sensitive information by would-be attackers.

## Description

### BACKGROUND

New trends in integrated circuit manufacturing and packaging have led to the relocation of die-internal signals to the die boundary and upper metal layers, making them more susceptible to physical probing attacks. Additionally, die disaggregation has shifted signals that were once internal to the die to semi-external buses, such as bridge circuitry dies (e.g., Intel^{®} Embedded Multi-die Interconnect Bridges (EMIBs)), further increasing their vulnerability. Existing solutions, such as cryptological methods and internal interposer routing, offer limited protection and do not address the comprehensive security needs of signals routed in the upper metal layers, particularly in multi-die configurations.

### BRIEF DESCRIPTION OF THE DRAWINGS

FIG. 1 illustrates a side view of an example integrated circuit package that includes a shielding die in accordance with embodiments herein.
FIG. 2 illustrates an exploded perspective view of the integrated circuit package of FIG. 1.
FIG. 3 illustrates a side view of another example integrated circuit package that includes a shielding die in accordance with embodiments herein.
FIG. 4 illustrates a side view of yet another example integrated circuit package that includes a shielding die in accordance with embodiments herein.
FIG. 5 is a top view of a wafer with dies that may be included in any of the embodiments disclosed herein.
FIG. 6 is a cross-sectional view of an integrated circuit device that may be included in any of the embodiments disclosed herein.
FIG. 7 is a cross-sectional view of an integrated circuit device assembly that may be included in embodiments disclosed herein.
FIG. 8 is a block diagram of an example electrical device that may include any of the embodiments disclosed herein.

### DETAILED DESCRIPTION

Advancements in integrated circuit manufacturing and packaging have led to a shift in the placement of die-internal signals. These signals are increasingly being routed to the die boundary and upper metal layers, making them more susceptible to physical probing attacks. This vulnerability is further exacerbated by the trend of die disaggregation, which moves signals that were once internal to the die to semi-external buses, such as die-to-die bridge circuitry dies (e.g., Intel^{®} Embedded Multi-die Interconnect Bridges (EMIBs)), thereby increasing their exposure to potential physical attack threats (e.g., electromagnetic (EM) and photonic fault insertion, as well as contact and contactless signal probing).

Existing solutions to protect die-to-die signals include routing important signals through internal interposer layers that are more challenging to probe, or introducing cryptological techniques, such as authenticated encryption. However, these methods are limited in scope and do not provide a comprehensive solution for signals routed in the upper metal layers of dies, particularly those associated with technology to provide backside power delivery to dies (e.g., Intel^{®} PowerVia technology). Current practices rely on ad-hoc methods and design phase guidelines to mitigate the risk of physical attacks on these signals. Additionally, active shielding techniques, which utilize the die's upper metal routing to shield lower metal layer signal traces, are confined to single-die protection and do not extend to multi-die packaging (e.g., die-to-die signal protection). While shielding solutions implemented at the printed circuit board (PCB) level exist, they fail to offer protection at the package level. Backside power delivery-compatible dies often employ a passive "carrier wafer" for mechanical support, but this can be easily removed, exposing the dies underneath.

The present disclosure may address these or other vulnerabilities by implementing a shielding die that sits above the multiple integrated circuit dies of a multi-die package and provides comprehensive protection for the packaged dies and their inter-die connectivity. The shielding die may cover all packaged dies and inter-die connectivity signals, offering a robust physical and technological barrier against probing attacks. The shielding die may be electrically connected to the dies of the package via a lower interposer beneath the dies and/or may be directly connected to the dies (e.g., in backside power delivery embodiments).

The shielding die and accompanying package may be designed such that that when the shielding die is removed or tampered with in some manner, access to any confidential information or assets in the package would be prevented, thereby safeguarding sensitive information while still allowing for secure debugging. For instance, packaged dies could initiate a "block-on-debug" configuration to eliminate the usage of secret values, delete secret values or information (e.g., authentication information), cryptographic keys or authentication certificates, or disable processing or other functions of the die(s). This approach not only enhances the security properties of the platform by hardening the packaged components against physical attacks (e.g., side channel and EM or laser fault insertion), but also maintains compatibility with existing packaging technologies, offering a cost-effective solution to a pressing industry challenge.

Further, embodiments herein allow for secure debugging of a package without exposing confidential aspects of the integrated circuit dies or other components of the package when the shielding die is removed. Package-level debug may require removal of the shielding die to enable access to components of the package. Thus, in embodiments where "block-on-debug" is activated by removal of the shielding die, enhanced protection may be provided for dies or components during debug operations.

Reference is now made to the drawings, which are not necessarily drawn to scale, wherein similar or same numbers may be used to designate same or similar parts in different figures. The use of similar or same numbers in different figures does not mean all figures including similar or same numbers constitute a single or same embodiment. Like numerals having different letter suffixes may represent different instances of similar components. The drawings illustrate generally, by way of example, but not by way of limitation, various embodiments discussed in the present document.

It is to be understood that drawings illustrate idealized versions of structure cross-sections. In actual cross-sections, the lines, layers, and other elements illustrated in the drawings can have shapes that vary from those illustrated. For example, surfaces illustrated as planar possess undulations, bumps, or dishing features; sidewalls can have a taper to them; ninety-degree corners can be rounded; and lines, layers, and features can overlap more or less than illustrated.

In the following description, for purposes of explanation, numerous specific details are set forth in order to provide a thorough understanding thereof. It may be evident, however, that the novel embodiments can be practiced without these specific details. In other instances, well-known structures and devices are shown in block diagram form in order to facilitate a description thereof. The intention is to cover all modifications, equivalents, and alternatives within the scope of the claims.

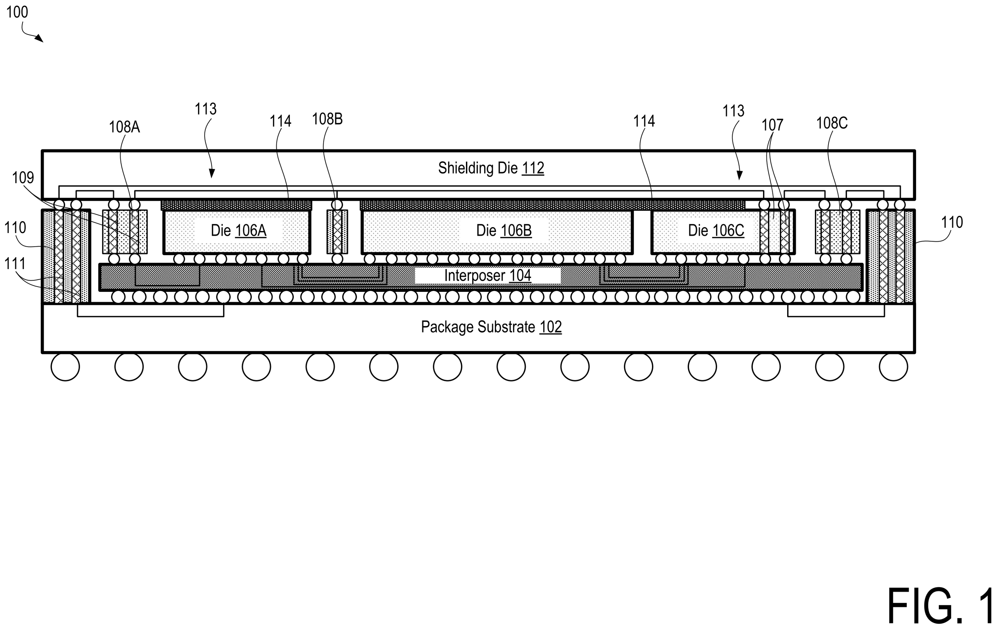

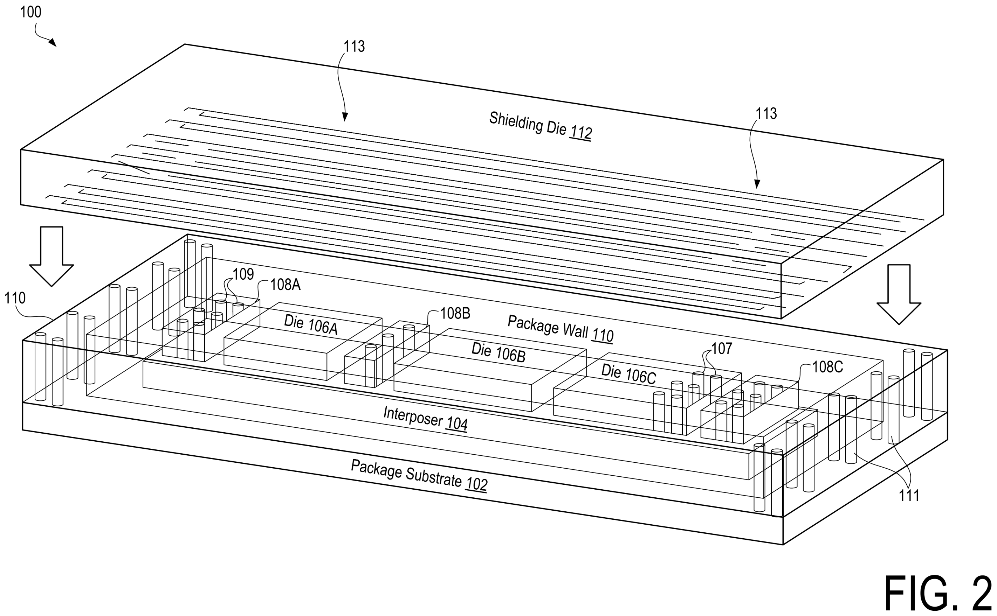

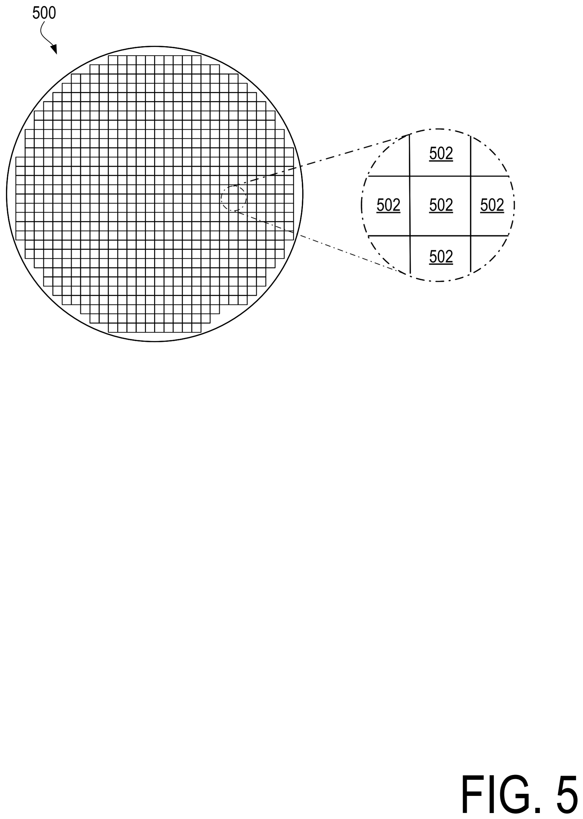

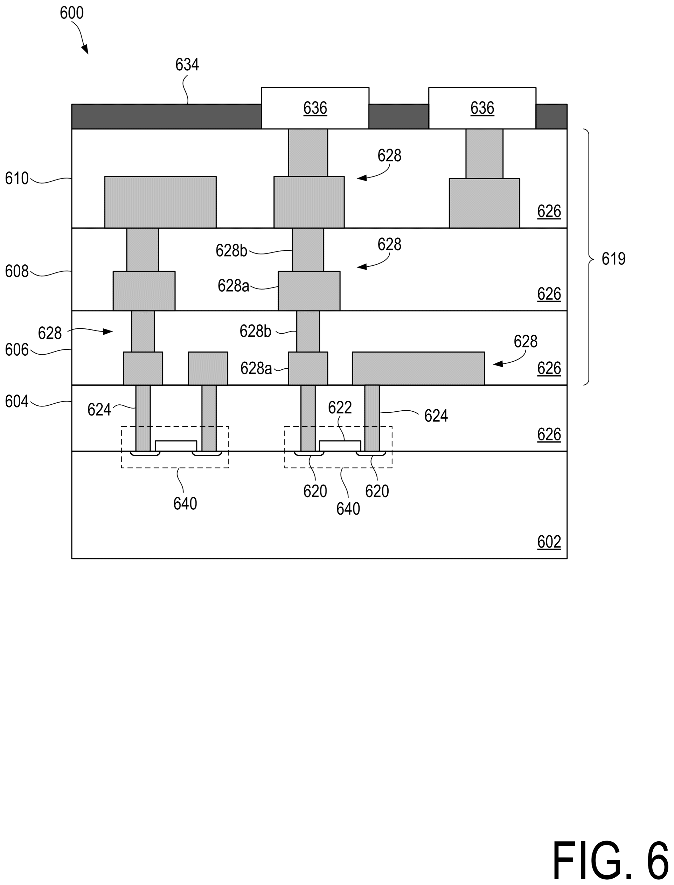

FIG. 1 illustrates a side view of an example integrated circuit package 100 that includes a shielding die in accordance with embodiments herein, while FIG. 2 illustrates an exploded perspective view of the package 100 of FIG. 1. In some cases, the package 100 may be referred to as a packaged integrated circuit component. The example package 100 includes a package substrate 102 with integrated circuit dies 106A-C attached to the package substrate 102 via an interposer 104. The dies 106A-C may be a packaged or unpacked integrated circuit product that includes one or more integrated circuit dies (e.g., the die 502 of FIG. 5, the integrated circuit structure 600 of FIG. 6) and/or one or more other suitable components. The dies 106A-C can comprise one or more computing system components, such as one or more processor units (e.g., system-on-a-chip (SoC), processor core, graphics processor unit (GPU), accelerator, chipset processor), I/O controller, memory, or network interface controller.

In some embodiments, the dies 106A-C can comprise one or more additional active or passive devices such as capacitors, decoupling capacitors, resistors, inductors, fuses, diodes, transformers, sensors, electrostatic discharge (ESD) devices, and memory devices. In addition to comprising one or more processor units, the dies 106A-C can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units.

The example package 100 further includes a shielding die 112 above each of the dies 106A-C, such that it covers the entirety of the top sides/upper surfaces of the dies. Although the example shielding die 112 covers the entirety of the dies beneath it, other embodiments may cover another portion of the overall package, e.g., may only cover certain dies (or portions of dies) of the package. The shielding die 112 may also cover additional area of the package 100 beyond the outer edges of the dies 106A-C, as shown. One or more layers 114 of material may be disposed between the dies 106A-C and the shielding die 112 as shown. In some embodiments, the layers 114 may be a metal film, which can provide an additional passive barrier for enhanced protection of the covered areas from optical or electromagnetic probing threats (e.g. laser fault injection, laser probing, emission microscopy, EM fault insertion, etc.).

The shielding die 112 includes conductive (e.g., metal) traces 113 therein, which connect to vias in one or more of the dies 106A-C (e.g., vias 107 in the die 106C), within one or more interposers of the package (e.g., vias 109 in interposer 108A), or vias within other structures of the package (e.g., the vias 111 within the package wall structure 110). The interposer 104 includes traces that provide electrical connections between respective dies, between one of the dies 106A-C and one of the interposers 108A-C, or between respective ones of the interposers 108A-C. In some embodiments, such as the one shown in FIG. 1, at least certain of the traces 113 may substantially traverse the length of the shielding die 112. As used herein, "substantially traverse" may refer to the traces 113 extending across a large portion of the length of the shielding die, e.g., some of the traces 113 may be extend across greater than 70% of the length of the shielding die 112. This may provide further security by minimizing areas of the shielding die 112 that might be vulnerable to a would-be attacker. In certain embodiments, the shielding die 112 includes only passive traces 113 and does not include circuit components, e.g., resistors, capacitors, etc., or any active components.

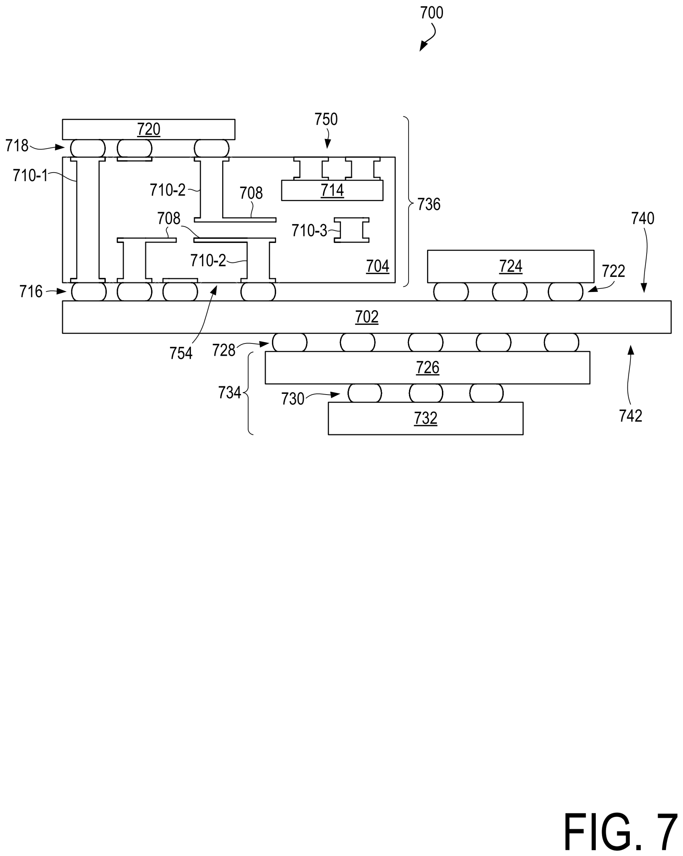

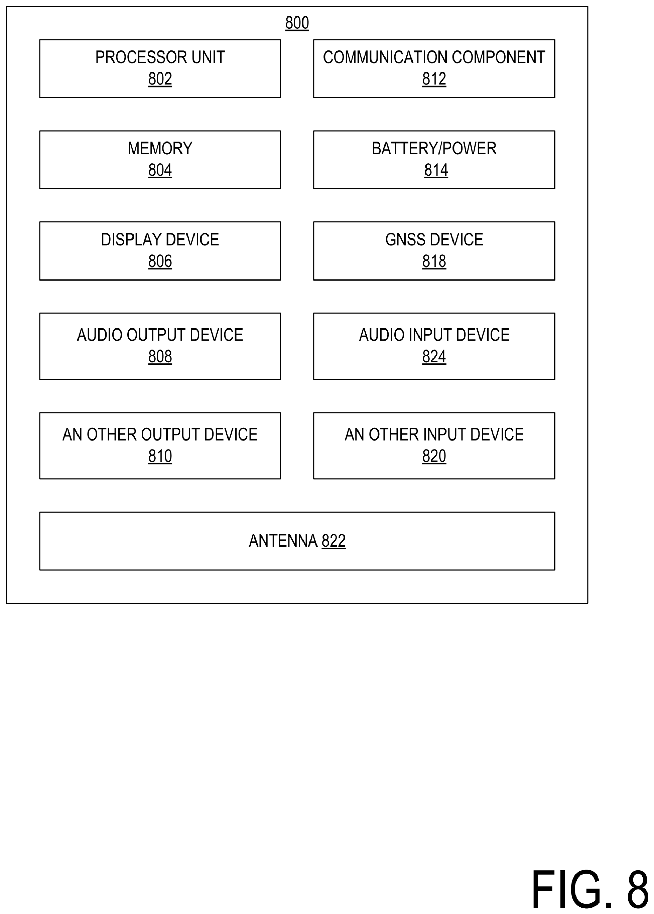

The example package 100 may be designed to be coupled to a circuit board (e.g., circuit board 702 of FIG. 7), which may be implemented as a motherboard or main board of a computer system in some embodiments. For example, the main circuit board may provide electrical connections between the dies and other components of a computer system, e.g., memory, storage, network interfaces, peripheral devices, power supplies, etc. (e.g., one or more of the components shown in FIG. 8 and described below). The main circuit board may include one or more traces and circuit components to provide interconnects between such computer system components.

As shown in FIG. 1, the shielding die 112 is electrically conductively coupled to the package substrate 102 and the dies 106A-C through the traces 113, and connections between the traces 113 and the dies 106A-C may be made directly or indirectly. For instance, some conductive connections may be made indirectly between the shielding die 112 and one of the dies 106A-C through one or more of the following: traces in the package substrate 102, traces in the interposer 104, vias in an interposer 108A, 108B, or 108C, and/or through vias in the package wall structure 110 (which surrounds each of the dies 106A-C of the package 100 as shown in FIG. 2 and may be itself considered as a type of interposer). Further, in some cases, traces of the shielding die 112 may be directly connected to the dies through an upper surface of the die (e.g., as shown with die 106C in FIG. 1). In embodiments implementing back side power delivery techniques, power may be delivered to one or more of the dies through the traces 113 in the shielding die 112 (e.g., one of the traces 113 connected to the die 106C may be a power delivery signal).

The package wall structure 110 and shielding die 112 provide a physical barrier to the dies 106A-C, aiding somewhat in the prevention of probing attacks. In addition, the traces 113 of the shielding die 112 and/or the vias 111 of the package wall structure 110 can be used to implement additional protection of the dies 106A-C. In particular, the dies 106A-C may be configured such that the signals provided through the traces 113 are needed for proper operation. For example, in certain embodiments, if the shielding die 112 is removed or traces 113 of the shielding die 112 are destroyed (thereby causing an open circuit in circuits comprising the traces 113), certain functionalities of the dies 106A-C may be disabled, in part or in full. For instance, confidential or otherwise sensitive data handling functionalities of a die may be disabled in such an instance, while other basic functionalities may remain. This bifurcation of protection can allow for protection of sensitive data processed by or otherwise present in the die while also allowing for secure debug of the die (e.g., when the shielding die 112 is not attached to the package 100).

As an example, the shielding die 112 may provide traces for passing or otherwise transmitting certain signals between the packaged dies, which when detected to be absent by a die (indicating removal, tampering, or destruction of the shielding die 112), will cause the dies to disable certain functionality. The shielding die 112 may, for example, pass a static value (e.g., binary (1/0) value or another type of value) to the dies to indicate the presence of the shielding die 112 on the package. As another example, the shielding die 112 may pass dynamic values between the packaged dies to indicate the presence of the shielding die 112, e.g., passing incrementing counter values that are expected to continually increase during operation.

In some embodiments, the shielding die 112 may incorporate information necessary for platform functionality, such as a package-specific identifier, and dies may need to obtain such information to provide full functionality. For instance, the shielding die 112 may contain a unique value stored, e.g., in the metal traces 113 (produced, for example, by laser cutting techniques), which would enable cryptographic pairing of the shielding die 112 with the other dies in the package 100. For example, a cryptographic key may be split into two shares when one share being stored in a die internal one time programmable (OTP) memory, and the other share is on the shielding die 112. Thus, without the shielding die 112 being present and connected, the cryptographic key cannot be obtained or otherwise recovered. In some instances, the key share stored on the shielding die 112 might not require confidentiality.

In some embodiments, the dies 106A-C may include logic to detect changes in the electrical properties (e.g., resistance, capacitance, or inductance) of a circuit in which the traces of the shielding die 112 are implemented. Tampering with the shielding die 112 (including slight changes to the traces by an attacker without removing the electrical connectivity) would cause changes in electrical properties, such as capacitance. The die, upon detection of such changes, could then disable certain functionality in response to detecting the capacitance change. This mitigates the potential for an attacker thinning an upper part of the shielding die 112 (while maintaining the connectivity of the traces 113) to get closer to the packaged dies 106A-C.

The shielding die 112 and package wall structure 110 may accordingly mitigate some physical attacks that require access to packaged elements during functional work, both because of the mechanical presence of the shielding die 112 (covering, for example, the die-to-die connectivity) and because functionality of dies or other assets of the package are blocked or disabled if the shielding die 112 connectivity is destroyed, faulty, or removed. In addition, attacks that require proximity to the die but not full electrical connection (e.g., various electromagnetic (EM) radiation-based attacks) may also be hindered because the mere presence of the shielding provided by the package wall structure 110 and the shielding die 112 forces an attacker to place an antenna or other attack tools at a greater distance from the packaged dies.

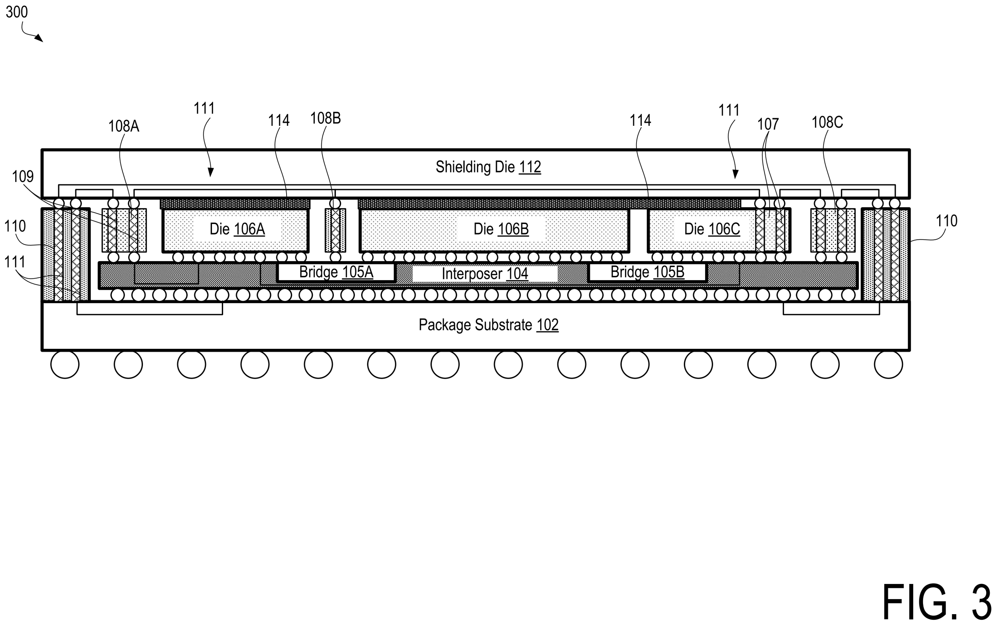

FIG. 3 illustrates a side view of another example integrated circuit package 300 that includes a shielding die in accordance with embodiments herein. The package 300 is the same as the package 100 described above, except that the package 300 includes bridge circuitry dies 105A, 105B in the interposer 104 to provide die-to-die connections. In particular, the bridge circuitry die 105A interconnects the die 106A and the die 106B while the bridge circuitry die 105B interconnects the die 106B and the die 106C. The bridge circuitry dies 105A, 105B may be implemented as Intel^{®} Embedded Multi-die Interconnect Bridges (EMIBs) in certain embodiments. The shielding die 112 may provide protection from attacks of the traces/circuitry within the bridge circuitry dies 105A, 105B in the same manners as the protection provided to the dies 106A-C.

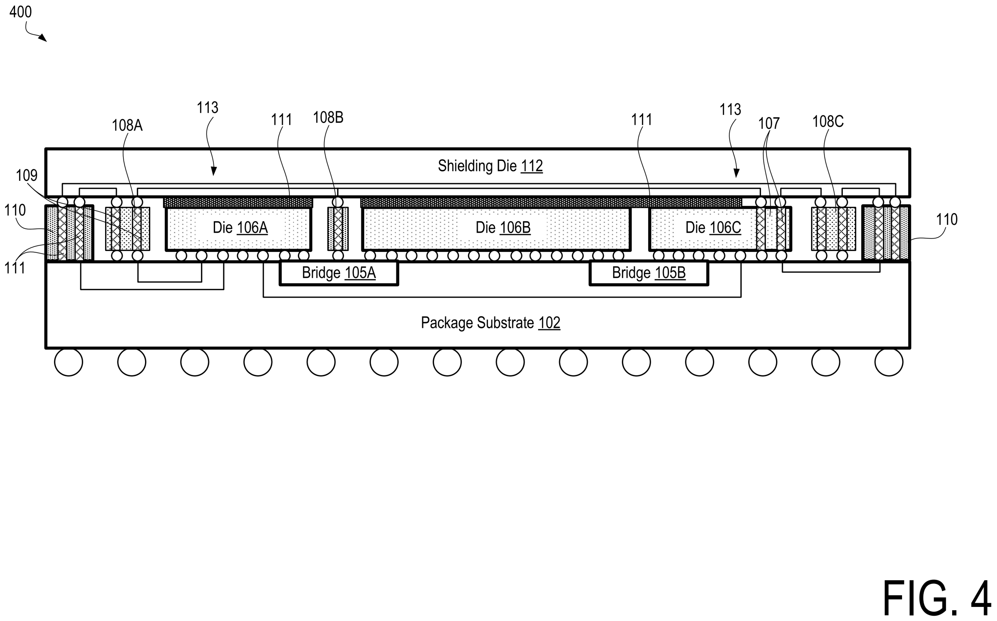

FIG. 4 illustrates a side view of yet another example integrated circuit package 400 that includes a shielding die in accordance with embodiments herein. The package 400 includes similar components to the packages 100, 300, but does not include the interposer 104. For instance, the package 400 includes bridge circuitry dies 105A, 105B within the package substrate 102 instead of within an interposer 104 as shown in FIG. 3.

FIG. 5 is a top view of a wafer 500 with dies 502 that may be included in any of the embodiments disclosed herein. The wafer 500 may be composed of semiconductor material and dies 502 having integrated circuit structures formed on a surface of the wafer 500. The individual dies 502 may be a repeating unit of an integrated circuit product that includes any suitable integrated circuit. After the fabrication of the semiconductor product is complete, the wafer 500 may undergo a singulation process in which the dies 502 are separated from one another to provide discrete "chips" of the integrated circuit product. The dies 502 may be any of the dies 106A-C disclosed herein. The dies 502 may include one or more transistors (e.g., transistors 640 of FIG. 6, discussed below), supporting circuitry to route electrical signals to the transistors, passive components (e.g., signal traces, resistors, capacitors, or inductors), and/or any other integrated circuit components that can be fabricated on the wafer. In some embodiments, the wafer 500 or the dies 502 may include a memory device (e.g., a random access memory (RAM) device, such as a static RAM (SRAM) device, a magnetic RAM (MRAM) device, a resistive RAM (RRAM) device, a conductive-bridging RAM (CBRAM) device, etc.), logic gates (e.g., AND, OR, NAND, and NOR gates), or any other suitable circuit element. Multiple ones of these devices and components may be combined on a single die. For example, a memory array formed by multiple memory devices may be formed on the same die as a processor unit or other logic configured to store information in the memory devices or execute instructions stored in the memory array.

FIG. 6 is a cross-sectional view of an integrated circuit structure 600 that may be included in any of the embodiments disclosed herein (e.g., in any of the dies 106A-C). Multiple instances of the integrated circuit structure 600 may be included in the dies 502 (FIG. 5). The integrated circuit structure 600 may be formed on a die substrate 602. The die substrate 602 may be a semiconductor substrate composed of semiconductor material including, for example, n-type or p-type materials (or a combination of both). The die substrate 602 may include, for example, a crystalline substrate formed using a bulk silicon or a silicon-on-insulator (SOI) substructure. In some embodiments, the die substrate 602 can comprise a layer of silicon on top of an SOI layer with bulk silicon below the SOI layer. In some embodiments, the die substrate 602 may be formed using alternative materials, which may or may not be combined with silicon, that include, but are not limited to, germanium, indium antimonide, lead telluride, indium arsenide, indium phosphide, gallium arsenide, or gallium antimonide. Further materials classified as group II-VI, III-V, or IV may also be used to form the die substrate 602. Although a few examples of materials from which the die substrate 602 may be formed are described here, any material that may serve as a foundation for an integrated circuit structure 600 may be used. The die substrate 602 may be part of a singulated die (e.g., dies 502 of FIG. 5) or a wafer (e.g., wafer 500 of FIG. 5).

The integrated circuit structure 600 may include device layer 604 disposed on the die substrate 602. The device layer 604 may include features of transistors 640 (e.g., metal oxide semiconductor field-effect transistors (MOSFETs)) formed on the die substrate 602. The transistors 640 may include, for example, source and drain regions (S/D regions 620), a gate 622 to control current flow between the S/D regions 620, and S/D contacts 624 to route electrical signals to and from the S/D regions 620. The transistors 640 may include additional features not depicted for the sake of clarity, such as device isolation regions, gate contacts, and the like. The transistors 640 are not limited to the type and configuration depicted in FIG. 6 and may include a wide variety of other types and configurations such as, for example, non-planar transistors, or a combination of planar and non-planar transistors. Non-planar transistors may include FinFET transistors, such as double-gate transistors or tri-gate transistors, and wrap-around or all-around gate transistors, such as nanoribbon, nanosheet, or nanowire transistors.

Transistors 640 may include a gate 622 formed of at least two layers, a gate dielectric, and a gate electrode. The gate dielectric may include one or more layers. The one or more layers may include silicon oxide, silicon dioxide, silicon carbide, and/or a high-k dielectric material.

The high-k dielectric material may include elements such as hafnium, silicon, oxygen, titanium, tantalum, lanthanum, aluminum, zirconium, barium, strontium, yttrium, lead, scandium, niobium, and zinc. Examples of high-k materials that may be used in the gate dielectric include, but are not limited to, hafnium oxide, hafnium silicon oxide, lanthanum oxide, lanthanum aluminum oxide, zirconium oxide, zirconium silicon oxide, tantalum oxide, titanium oxide, barium strontium titanium oxide, barium titanium oxide, strontium titanium oxide, yttrium oxide, aluminum oxide, lead scandium tantalum oxide, and lead zinc niobate. In some embodiments, an annealing process may be carried out on the gate dielectric to improve its quality when a high-k material is used.

The gate electrode may be formed on the gate dielectric and may include at least one p-type work function metal or n-type work function metal, depending on whether the transistor is to be a p-type metal oxide semiconductor (PMOS) or an n-type metal oxide semiconductor (NMOS) transistor. In some implementations, the gate electrode may consist of a stack of two or more metal layers, where one or more metal layers are work function metal layers and at least one metal layer is a fill metal layer. Further metal layers may be included for other purposes, such as a barrier layer.

For PMOS transistors, metals that may be used for the gate electrode include, but are not limited to, ruthenium, palladium, platinum, cobalt, nickel, conductive metal oxides (e.g., ruthenium oxide), and any of the metals discussed below with reference to an NMOS transistor (e.g., for work function tuning). For NMOS transistors, metals that may be used for the gate electrode include, but are not limited to, hafnium, zirconium, titanium, tantalum, aluminum, alloys of these metals, carbides of these metals (e.g., hafnium carbide, zirconium carbide, titanium carbide, tantalum carbide, and aluminum carbide), and any of the metals discussed above with reference to a PMOS transistor (e.g., for work function tuning).

In some embodiments, a pair of sidewall spacers may be formed on opposing sides of the gate stack (comprising the gate dielectric and the gate electrode) to bracket the gate stack. The sidewall spacers may be formed from materials such as silicon nitride, silicon oxide, silicon carbide, silicon nitride doped with carbon, and silicon oxynitride. Processes for forming sidewall spacers are well known in the art and generally include deposition and etching process steps. In some embodiments, a plurality of sidewall spacer pairs may be used; for instance, two pairs, three pairs, or four pairs of sidewall spacers may be formed on opposing sides of the gate stack.

The S/D regions 620 may be formed within the die substrate 602 adjacent to the gate 622 of transistors 640. The S/D regions 620 may be formed using an implantation/diffusion process or an etching/deposition process, for example. In the former process, dopants such as boron, aluminum, antimony, phosphorous, or arsenic may be ion-implanted into the die substrate 602 to form the S/D regions 620. An annealing process that activates the dopants and causes them to diffuse further into the die substrate 602 may follow the ion implantation process. In the latter process, the die substrate 602 may first be etched to form recesses at the locations of the S/D regions 620. An epitaxial deposition process may then be carried out to fill the recesses with material that is used to fabricate the S/D regions 620. In some implementations, the S/D regions 620 may be fabricated using a silicon alloy such as silicon germanium or silicon carbide. In some embodiments, the epitaxially deposited silicon alloy may be doped in situ with dopants such as boron, arsenic, or phosphorous. In some embodiments, the S/D regions 620 may be formed using one or more alternate semiconductor materials such as germanium or a group III-V material or alloy. In further embodiments, one or more layers of metal and/or metal alloys may be used to form the S/D regions 620.

Electrical signals, such as power and/or information-carrying signals (e.g., input/output (I/O) signals, may be routed to and/or from devices (e.g., transistors 640) of the device layer 604 through one or more interconnect layers disposed on the device layer 604 (illustrated in FIG. 6 as interconnect layers 606-610). For example, electrically conductive features of the device layer 604 (e.g., the gate 622 and the S/D contacts 624) may be electrically coupled with interconnect structures 628 of the interconnect layers 606-610. The one or more interconnect layers 606-610 may form a metallization stack 619 (which can also be referred to as an "ILD stack" (inter-layer dielectric stack)) of the integrated circuit structure 600.

The interconnect structures 628 may be arranged within the interconnect layers 606-610 to route electrical signals according to a wide variety of designs; in particular, the arrangement is not limited to the particular configuration of interconnect structures 628 depicted in FIG. 6. Although a particular number of interconnect layers 606-610 is depicted in FIG. 6, embodiments of the present disclosure include integrated circuit structures having more or fewer interconnect layers than depicted.

In some embodiments, the interconnect structures 628 may include traces or lines 628a and/or vias 628b filled with an electrically conductive material such as a metal. The lines 628a may be arranged to route electrical signals in a direction of a plane that is substantially parallel with a surface of the die substrate 602 upon which the device layer 604 is formed. For example, the lines 628a may route electrical signals in a direction in and out of the page and/or in a direction across the page from the perspective of FIG. 6. The vias 628b may be arranged to route electrical signals in a direction of a plane that is substantially perpendicular to the surface of the die substrate 602 upon which the device layer 604 is formed. In some embodiments, lines 628a of different interconnect layers 606-610 are electrically coupled by vias 628b.

The interconnect layers 606-610 may include a dielectric material 626 within which the interconnect structures 628 are disposed, as shown in FIG. 6. In some embodiments, dielectric material 626 in different ones of the interconnect layers 606-610 may have different compositions; in other embodiments, the composition of the dielectric material 626 between different interconnect layers 606-610 may be the same. The device layer 604 may include a dielectric material 626 within which the transistors 640 are disposed and upon which a bottom layer of the metallization stack is located. The dielectric material 626 that is part of the device layer 604 may have a different composition than the dielectric material 626 included in the interconnect layers 606-610; in other embodiments, the composition of the dielectric material 626 in the device layer 604 may be the same as a dielectric material 626 included in any one of the interconnect layers 606-610.

A first interconnect layer 606 (which can be referred to as a Metal 1 or "M1" layer) may be formed directly on the device layer 604. In some embodiments, the first interconnect layer 606 may include lines 628a and/or vias 628b, as shown. The lines 628a of the first interconnect layer 606 may be coupled with contacts (e.g., the S/D contacts 624) of the device layer 604. The vias 628b of the first interconnect layer 606 may be coupled with the lines 628a of a second interconnect layer 608.

The second interconnect layer 608 (which can be referred to as a Metal 2 or "M2" layer) may be formed directly on the first interconnect layer 606. In some embodiments, the second interconnect layer 608 may include vias 628b to couple the lines 628a of the second interconnect layer 608 with the lines 628a of a third interconnect layer 610. Although the lines 628a and the vias 628b are structurally delineated with a line within individual interconnect layers for the sake of clarity, the lines 628a and the vias 628b may be structurally and/or materially contiguous (e.g., simultaneously filled during a dual-damascene process) in some embodiments.

The third interconnect layer 610 (which can be referred to as a Metal 3 or "M3" layer) (and additional interconnect layers, as desired) may be formed in succession on the second interconnect layer 608 according to similar techniques and configurations described in connection with the second interconnect layer 608 or the first interconnect layer 606. In some embodiments, the interconnect layers that are "higher up" in the metallization stack 619 in the integrated circuit structure 600 (i.e., farther away from the device layer 604) may be thicker than the interconnect layers that are lower in the metallization stack 619, with lines 628a and vias 628b in the higher interconnect layers being thicker than those in the lower interconnect layers.

The integrated circuit structure 600 may include a solder resist material 634 (e.g., polyimide or similar material) and conductive contacts 636 formed on the stack of interconnect layers 606-610. In FIG. 6, the conductive contacts 636 are illustrated as taking the form of bond pads. The conductive contacts 636 may be electrically coupled with interconnect structures 628 of the top-most layer in the metallization stack 619 and configured to route electrical signals between the transistors 640 and components external to the integrated circuit structure 600. For example, solder bonds may be formed on the conductive contacts 636 to mechanically and/or electrically couple an integrated circuit component comprising the integrated circuit structure 600 with another component (e.g., a printed circuit board). The integrated circuit structure 600 may include additional or alternate structures to route electrical signals from the interconnect layers 606-610; for example, the conductive contacts 636 may include other analogous features (e.g., posts) that can route the electrical signals between the transistors 640 and external components.

In some embodiments in which the integrated circuit structure 600 is part of a double-sided die, the integrated circuit structure 600 may include a second metallization stack (not shown) located on the opposite side of the die substrate 602 from the device layer 604. This second metallization stack may include multiple interconnect layers as discussed above with reference to the interconnect layers 606-610. Through-silicon vias (TSVs) that extend through the die substrate 602 can provide electrically conductive pathways from the transistors 640 to the second metallization stack and the second metallizaton stack can electrically couple the TSVs to additional conductive contacts (not shown) located on the opposite side of the integrated circuit structure 600 from the conductive contacts 636.

In some embodiments, TSVs extending through the die substrate 602 can be used for routing power and ground signals from conductive contacts located on the opposite side of the integrated circuit structure 600 from the conductive contacts 636 to the transistors 640 and any other components integrated into the integrated circuit structure 600, and the metallization stack 619 can be used to route information-carrying signals from the conductive contacts 636 to transistors 640 and any other components integrated into the integrated circuit structure 600. Put another way, the routing of power and ground signals to the transistors 640 can be separated (via a back-side or bottom-side metallizaton stack and TSVs) from the routing of information-carrying signals to the transistors. The power and ground signals are provided by a backside or bottom-side metallization stack and TSVs, and information-carrying signals are provided by a topside metallization stack (e.g., metallization stack 619).

Several integrated circuit dies may be stacked with one or more TSVs in the individual stacked dies providing connection between one of the dies to any of the other dies in the stack. For example, one or more high-bandwidth memory (HBM) integrated circuit dies can be stacked on top of a base integrated circuit die and TSVs in the HBM dies can provide connection between the individual HBM dies and the base integrated circuit die. Conductive contacts can provide additional connections between adjacent integrated circuit dies in the stack. In some embodiments, the conductive contacts can be fine-pitch solder bumps (microbumps).

FIG. 7 is a cross-sectional view of an integrated circuit device assembly 700. The integrated circuit device assembly 700 includes a number of components disposed on a circuit board 702 (which may be a motherboard, system board, mainboard, etc.). The integrated circuit device assembly 700 includes components disposed on a first face 740 of the circuit board 702 and a second face 742 of the circuit board 702, the second face 742 opposing the first face 740. Generally, components may be disposed on either or both of the first face 740 and the second face 742 of the circuit board 702.

In some embodiments, the circuit board 702 may be a printed circuit board (PCB) including multiple metal (or interconnect) layers separated from one another by layers of dielectric material and interconnected by electrically conductive vias. The individual metal layers comprise conductive traces. The metal layers may be formed in a desired pattern to route electrical signals between the components electrically coupled to the circuit board 702. In other embodiments, the circuit board 702 may be a non-PCB substrate. In some embodiments the circuit board 702 may be, for example, the package substrate 102 or a circuit board (e.g., mainboard or mother board) to which the package substrate 102 is attached.

The integrated circuit device assembly 700 illustrated in FIG. 7 includes a package-on-interposer structure 736 coupled to the first face 740 of the circuit board 702 by coupling components 716. The coupling components 716 may electrically and mechanically couple the package-on-interposer structure 736 to the circuit board 702 and may include solder balls (as shown in FIG. 7), pins (e.g., as part of a pin grid array (PGA), contacts (e.g., as part of a land grid array (LGA)), male and female portions of a socket, an adhesive, an underfill material, and/or any other suitable electrical and/or mechanical coupling structure. (Thus, a coupling component may comprise a conductive contact.)

The package-on-interposer structure 736 may include an integrated circuit component 720 coupled to an interposer 704. The interposer 704 may provide an intervening substrate used to bridge the circuit board 702 and the integrated circuit component 720. The integrated circuit component 720 is coupled to the interposer 704 by coupling components 718. The coupling components 718 may take any suitable form, such as the forms discussed above with reference to the coupling components 716. Although FIG. 7 shows just one integrated circuit component attached to the interposer, multiple integrated circuit components may be coupled to the interposer 704. Additional interposers may be coupled to the interposer 704.

The integrated circuit component 720 may be a packaged or unpacked integrated circuit product that includes one or more integrated circuit dies (e.g., the die 502 of FIG. 5, a die comprising the integrated circuit structure 600 of FIG. 6) and/or one or more other suitable components. A packaged integrated circuit component comprises one or more integrated circuit dies mounted on a package substrate with the integrated circuit dies and package substrate encapsulated in a casing material, such as a metal, plastic, glass, or ceramic. In one unpackaged example of an integrated circuit component 720, a single monolithic integrated circuit die comprises solder bumps attached to contacts on the die. The solder bumps allow the die to be directly attached to the interposer 704. The integrated circuit component 720 can comprise one or more computing system components, such as one or more processor units (e.g., system-on-a-chip (SoC), processor core, graphics processor unit (GPU), accelerator, chipset processor), I/O controller, memory, or network interface controller. In some embodiments, the integrated circuit component 720 can comprise one or more additional active or passive devices such as capacitors, decoupling capacitors, resistors, inductors, fuses, diodes, transformers, sensors, electrostatic discharge (ESD) devices, and memory devices.

In embodiments where the integrated circuit component 720 comprises multiple integrated circuit dies, the dies can be of the same type (a homogeneous multi-die integrated circuit component) or of two or more different types (a heterogeneous multi-die integrated circuit component). A multi-die integrated circuit component can be referred to as a multi-chip package (MCP) or multi-chip module (MCM).

In addition to comprising one or more processor units, the integrated circuit component 720 can comprise additional components, such as embedded DRAM, stacked high bandwidth memory (HBM), shared cache memories, input/output (I/O) controllers, or memory controllers. Any of these additional components can be located on the same integrated circuit die as a processor unit, or on one or more integrated circuit dies separate from the integrated circuit dies comprising the processor units. These separate integrated circuit dies can be referred to as "chiplets". In embodiments where an integrated circuit component comprises multiple integrated circuit dies, interconnections between dies can be provided by the package substrate, one or more silicon interposers, one or more silicon bridges embedded in the package substrate (such as Intel^{®} embedded multi-die interconnect bridges (EMIBs)), or combinations thereof.

Generally, the interposer 704 may spread connections to a wider or narrower pitch or reroute a connection to a different connection. For example, the interposer 704 may couple coupling components 718 having a first pitch to coupling components 716 having a wider pitch than the first pitch. In the embodiment illustrated in FIG. 7, the integrated circuit component 720 and the circuit board 702 are attached to opposing sides of the interposer 704. In other embodiments, the integrated circuit component 720 and the circuit board 702 may be attached to a same side of the interposer 704. In some embodiments, three or more components may be interconnected by way of the interposer 704.

In some embodiments, the interposer 704 may be formed as a PCB, including multiple metal layers separated from one another by layers of dielectric material and interconnected by electrically conductive vias. In some embodiments, the interposer 704 may be formed of an epoxy resin, a fiberglass-reinforced epoxy resin, an epoxy resin with inorganic fillers, a ceramic material, or a polymer material such as polyimide. In some embodiments, the interposer 704 may be formed of alternate rigid or flexible materials that may include the same materials described above for use in a semiconductor substrate, such as silicon, germanium, and other group III-V and group IV materials. The interposer 704 may include metal interconnects 708 and vias, including but not limited to through hole vias 710-1 (that extend from a first face 750 of the interposer 704 to a second face 754 of the interposer 704), blind vias 710-2 (that extend from the first face 750 or the second face 754 of the interposer 704 to an internal metal layer), and buried vias 710-3 (that connect internal metal layers).

In some embodiments, the interposer 704 can comprise a silicon interposer. Through silicon vias (TSV) extending through the silicon interposer can connect connections on a first face of a silicon interposer to an opposing second face of the silicon interposer. In some embodiments, an interposer 704 comprising a silicon interposer can further comprise one or more routing layers to route connections on a first face of the interposer 704 to an opposing second face of the interposer 704.

In some embodiments the interposer 704, as well as the circuit board 702, can comprise an amorphous solid layer of glass (which can be referred to a glass core or glass substrate). In some embodiments, the layer of glass can comprise silica (comprising silicon dioxide (SiO₂)), fused silica, aluminosilicate (comprising aluminum oxide (Al₂O₃) and silicon dioxide), borosilicate (comprising silicon dioxide and boron trioxide (B₂O₃)), or alumino-borosilicate (comprising aluminum oxide, silicon dioxide, and boron trioxide). In some embodiments, the layer of glass can comprise one or more of the following additives: aluminum oxide, boron trioxide, magnesium oxide (MgO), calcium oxide (CaO), strontium oxide (SrO), barium oxide (BaO), tin(IV) oxide (SnO₂), nitrous oxide (Na₂O), potassium oxide (K₂O), diphosphorous trioxide (P₂O₃), zirconium dioxide (ZrO₂), lithium oxide (Li₂O), titanium, and zinc. In some embodiments, the layer of glass can comprise silicon and oxygen, as well as one or more of aluminum, boron, magnesium, calcium, barium, tin, sodium, potassium, strontium, phosphorous, zirconium, lithium, titanium, and zinc. In some embodiments, the layer of glass comprises at least 23 percent silicon by weight, at least 26 percent oxygen by weight, and at least five percent aluminum by weight. In some embodiments, the layer of glass does not include an organic adhesive or an organic material. For example, the layer of glass is not a substrate or a board comprising glass fibers and an epoxy binder, such as a printed circuit board (PCB) comprising multiple metal (or interconnect) layers separated from one another by layers of dielectric material (e.g., FR-4 or other fiberglass-reinforced epoxy laminate) and interconnected by electrically conductive vias.

In some embodiments, the glass layer has a thickness in the range of about 50 microns to about 1.4 millimeters. In some embodiments, the glass layer is or is part of a multi-layer glass substrate (a coreless substrate). Individual glass layers in a multi-layer glass substrate can have a thickness in the range of about 25 microns to about 50 microns. In some embodiments, a glass layer can have a length in the range of about 10 millimeters to about 250 millimeters on a side (e.g., can have an area in the range of about 10 mm x 10 mm to about 250 mm x 250 mm). In some embodiments, the glass layer comprises a rectangular prism volume with sections or portions (e.g., through-glass vias) removed and filled with other metals (e.g., metal).

In some embodiments, redistribution layers (RDL) can be located on either or both sides of the glass layer to provide electrically conductive paths from top and/or bottom surfaces of the interposer 704 or circuit board 702 to the glass layer. The glass layer can comprise through-glass vias (TGVs) that extend through the glass layer to provide electrically conductive paths through the glass core, glass substrate, or glass layer.

The interposer 704 may further include embedded devices 714, including both passive and active devices. Such devices may include, but are not limited to, capacitors, decoupling capacitors, resistors, inductors, fuses, diodes, transformers, sensors, electrostatic discharge (ESD) devices, and memory devices. More complex devices such as radio frequency devices, power amplifiers, power management devices, antennas, arrays, sensors, and microelectromechanical systems (MEMS) devices may also be formed on the interposer 704. The package-on-interposer structure 736 may take the form of any of the package-on-interposer structures known in the art.

The integrated circuit device assembly 700 may include an integrated circuit component 724 coupled to the first face 740 of the circuit board 702 by coupling components 722. The coupling components 722 may take the form of any of the embodiments discussed above with reference to the coupling components 716, and the integrated circuit component 724 may take the form of any of the embodiments discussed above with reference to the integrated circuit component 720.

The integrated circuit device assembly 700 illustrated in FIG. 7 further includes a package-on-package structure 734 coupled to the second face 742 of the circuit board 702 by coupling components 728. The package-on-package structure 734 may include an integrated circuit component 726 and an integrated circuit component 732 coupled together by coupling components 730 such that the integrated circuit component 726 is disposed between the circuit board 702 and the integrated circuit component 732. The coupling components 728 and 730 may take the form of any of the embodiments of the coupling components 716 discussed above, and the integrated circuit components 726 and 732 may take the form of any of the embodiments of the integrated circuit component 720 discussed above. The package-on-package structure 734 may be configured in accordance with any of the package-on-package structures known in the art.

FIG. 8 is a block diagram of an example electrical device 800 that may include any of the microelectronic assemblies disclosed herein. For example, any suitable ones of the components of the electrical device 800 may include embodiments of the present disclosure, including one or more of the packages 100, 300, 400, one or more of the integrated circuit device assembly 700, the integrated circuit component 720, the integrated circuit structure 600, the integrated circuit dies 502, or other aspects disclosed herein. A number of components are illustrated in FIG. 8 as included in the electrical device 800, but any one or more of these components may be omitted or duplicated, as suitable for the application. In some embodiments, some or all of the components included in the electrical device 800 may be attached to one or more motherboards, mainboards, or system boards. In some embodiments, one or more of these components are fabricated onto a single system-on-a-chip (SoC) die.

Additionally, in various embodiments, the electrical device 800 may not include one or more of the components illustrated in FIG. 8, but the electrical device 800 may include interface circuitry for coupling to the one or more components. For example, the electrical device 800 may not include a display device 806, but may include display device interface circuitry (e.g., a connector and driver circuitry) to which a display device 806 may be coupled. In another set of examples, the electrical device 800 may not include an audio input device 824 or an audio output device 808, but may include audio input or output device interface circuitry (e.g., connectors and supporting circuitry) to which an audio input device 824 or audio output device 808 may be coupled.

The electrical device 800 may include one or more processor units 802. As used herein, the terms "processor unit," "processing unit," or "processor" may refer to any device or portion of a device that processes electronic data from registers and/or memory to transform that electronic data into other electronic data that may be stored in registers and/or memory. The one or more processor units 802 may include one or more digital signal processors (DSPs), application-specific integrated circuits (ASICs), central processing units (CPUs), graphics processing units (GPUs), general-purpose GPUs (GPGPUs), accelerated processing units (APUs), field-programmable gate arrays (FPGAs), neural network processing units (NPUs), data processor units (DPUs), accelerators (e.g., graphics accelerator, compression accelerator, artificial intelligence accelerator), controller cryptoprocessors (specialized processors that execute cryptographic algorithms within hardware), server processors, controllers, or any other suitable type of processor units. As such, the processor unit can be referred to as an XPU (or xPU).

The electrical device 800 may include a memory 804, which may itself include one or more memory devices such as volatile memory (e.g., dynamic random access memory (DRAM), static random-access memory (SRAM)), non-volatile memory (e.g., read-only memory (ROM), flash memory, chalcogenide-based phase-change non-voltage memories), solid state memory, and/or a hard drive. In some embodiments, the memory 804 may include memory that is located on the same integrated circuit die as the one or more processor units 802. This memory may be used as cache memory (e.g., Level 1 (L1), Level 2 (L2), Level 3 (L3), Level 4 (L4), Last Level Cache (LLC)) and may include embedded dynamic random-access memory (eDRAM) or spin transfer torque magnetic random-access memory (STT-MRAM).

In some embodiments of the electrical device 800, a first one of the one or more processor units 802 can be heterogeneous or asymmetric to a second one of the one or more processor units 802 in the electrical device 800. There can be a variety of differences between the one or more processor units 802 in a system in terms of a spectrum of metrics of merit including architectural, microarchitectural, thermal, power consumption characteristics, and the like. These differences can effectively manifest themselves as asymmetry and heterogeneity among the one or more processor units 802 in the electrical device 800.

In some embodiments, the electrical device 800 may include a communication component 812. For example, the communication component 812 can manage wireless communications for the transfer of data to and from the electrical device 800. The term "wireless" and its derivatives may be used to describe circuits, devices, systems, methods, techniques, communications channels, etc., that may communicate data through the use of modulated electromagnetic radiation through a nonsolid medium. The term "wireless" does not imply that the associated devices do not contain any wires, although in some embodiments they might not.

The communication component 812 may implement any of a number of wireless standards or protocols, including but not limited to Institute for Electrical and Electronic Engineers (IEEE) standards including Wi-Fi (IEEE 802.11 family), IEEE 802.16 standards (e.g., IEEE 802.16-2005 Amendment), Long-Term Evolution (LTE) project along with any amendments, updates, and/or revisions (e.g., advanced LTE project, ultra mobile broadband (UMB) project (also referred to as "3GPP2"), etc.). IEEE 802.16 compatible Broadband Wireless Access (BWA) networks are generally referred to as WiMAX networks, an acronym that stands for Worldwide Interoperability for Microwave Access, which is a certification mark for products that pass conformity and interoperability tests for the IEEE 802.16 standards. The communication component 812 may operate in accordance with a Global System for Mobile Communication (GSM), General Packet Radio Service (GPRS), Universal Mobile Telecommunications System (UMTS), High Speed Packet Access (HSPA), Evolved HSPA (E-HSPA), or LTE network. The communication component 812 may operate in accordance with Enhanced Data for GSM Evolution (EDGE), GSM EDGE Radio Access Network (GERAN), Universal Terrestrial Radio Access Network (UTRAN), or Evolved UTRAN (E-UTRAN). The communication component 812 may operate in accordance with Code Division Multiple Access (CDMA), Time Division Multiple Access (TDMA), Digital Enhanced Cordless Telecommunications (DECT), Evolution-Data Optimized (EV-DO), and derivatives thereof, as well as any other wireless protocols that are designated as 3G, 4G, 5G, and beyond. The communication component 812 may operate in accordance with other wireless protocols in other embodiments. The electrical device 800 may include an antenna 822 to facilitate wireless communications and/or to receive other wireless communications (such as AM or FM radio transmissions).

In some embodiments, the communication component 812 may manage wired communications, such as electrical, optical, or any other suitable communication protocols (e.g., IEEE 802.3 Ethernet standards). In some embodiments, the electrical device 800 comprises multiple communication components. For instance, a first communication component may be dedicated to shorter-range wireless communications such as Wi-Fi or Bluetooth, and a second communication component may be dedicated to longer-range wireless communications such as global positioning system (GPS), EDGE, GPRS, CDMA, WiMAX, LTE, EV-DO, or others. In some embodiments, a first communication component may be dedicated to wireless communications, and a second communication component may be dedicated to wired communications.

The electrical device 800 may include battery/power circuitry 814. The battery/power circuitry 814 may include one or more energy storage devices (e.g., batteries or capacitors) and/or circuitry for coupling components of the electrical device 800 to an energy source separate from the electrical device 800 (e.g., AC line power).

The electrical device 800 may include a display device 806 (or corresponding interface circuitry, as discussed above). The display device 806 may include one or more embedded or wired or wirelessly connected external visual indicators, such as a heads-up display, a computer monitor, a projector, a touchscreen display, a liquid crystal display (LCD), a light-emitting diode display, or a flat panel display.

The electrical device 800 may include an audio output device 808 (or corresponding interface circuitry, as discussed above). The audio output device 808 may include any embedded or wired or wirelessly connected external device that generates an audible indicator, such as speakers, headsets, or earbuds.

The electrical device 800 may include an audio input device 824 (or corresponding interface circuitry, as discussed above). The audio input device 824 may include any embedded or wired or wirelessly connected device that generates a signal representative of a sound, such as microphones, microphone arrays, or digital instruments (e.g., instruments having a musical instrument digital interface (MIDI) output). The electrical device 800 may include a Global Navigation Satellite System device (GNSS) (or corresponding interface circuitry, as discussed above), such as a Global Positioning System (GPS) device. The GNSS device 818 may be in communication with a satellite-based system and may determine a geolocation of the electrical device 800 based on information received from one or more GNSS satellites, as known in the art.

The electrical device 800 may include another output device 810 (or corresponding interface circuitry, as discussed above). Examples of the other output device 810 may include an audio codec, a video codec, a printer, a wired or wireless transmitter for providing information to other devices, or an additional storage device.

The electrical device 800 may include another input device 820 (or corresponding interface circuitry, as discussed above). Examples of the other input device 820 may include an accelerometer, a gyroscope, a compass, an image capture device (e.g., monoscopic or stereoscopic camera), a trackball, a trackpad, a touchpad, a keyboard, a cursor control device such as a mouse, a stylus, a touchscreen, proximity sensor, microphone, a bar code reader, a Quick Response (QR) code reader, electrocardiogram (ECG) sensor, PPG (photoplethysmogram) sensor, galvanic skin response sensor, any other sensor, or a radio frequency identification (RFID) reader.

The electrical device 800 may have any form factor, such as a hand-held or mobile electrical device (e.g., a cell phone, a smartphone, a mobile internet device, a music player, a tablet computer, a laptop computer, a 2-in-1 convertible computer, a portable all-in-one computer, a netbook computer, an ultrabook computer, a personal digital assistant (PDA), an ultra-mobile personal computer, a portable gaming console), a desktop electrical device, a server, a rack-level computing solution (e.g., blade, tray, or sled computing system), a workstation or other networked computing component, a printer, a scanner, a monitor, a set-top box, an entertainment control unit, a stationary gaming console, smart television, a vehicle control unit, a digital camera, a digital video recorder, a wearable electrical device or an embedded computing system (e.g., computing systems that are part of a vehicle, smart home appliance, consumer electronics product or equipment, manufacturing equipment). In some embodiments, the electrical device 800 may be any other electronic device that processes data. In some embodiments, the electrical device 800 may comprise multiple discrete physical components. Given the range of devices that the electrical device 800 can be manifested as in various embodiments, in some embodiments, the electrical device 800 can be referred to as a computing device or a computing system.

As used herein, "connected" may indicate elements are in direct physical or electrical contact with each other and "coupled" may indicate elements cooperate or interact with each other, but they may or may not be in direct physical or electrical contact. Furthermore, the terms "comprising," "including," "having," and the like, as used with respect to embodiments of the present disclosure, are synonymous. Terms modified by the word "substantially" include arrangements, orientations, spacings, or positions that vary slightly from the meaning of the unmodified term. For example, layers, faces, or features that are referred to as being substantially parallel can refer to layers, faces, or features that are within a few degrees of being parallel with each other, and layers, faces, or features that are referred to as being substantially perpendicular to each other can refer to features that are within +/- 15 degrees of being perpendicular to each other.

As used herein, the phrase "located on" in the context of a first layer or component located on a second layer or component refers to the first layer or component being directly physically attached to the second part or component (no layers or components between the first and second layers or components) or physically attached to the second layer or component with one or more intervening layers or components. As used herein, the term "adjacent" refers to layers or components that are arranged next to each other (e.g., side-by-side, top and bottom).

Certain terminology may also be used herein for the purpose of reference only, and thus are not intended to be limiting. For example, terms such as "upper," "lower," "above," "below," "bottom," and "top" refer to directions in the Figures to which reference is made. Terms such as "front," "back," "rear," and "side" describe the orientation and/or location of layers, components, portions of components, etc., within a consistent but arbitrary frame of reference, which is made clear by reference to the text and the associated Figures describing the layers, component, portions of components, etc. under discussion. Such terminology may include the words specifically mentioned above, derivatives thereof, and words of similar import. Further, "first," "second," "third," and the like describe a common object and indicate different instances of like objects being referred to. Such adjectives do not imply objects so described must be in a given sequence, either temporally or spatially, in ranking, or any other manner.

As used herein, the term "integrated circuit component" refers to a packaged or unpacked integrated circuit product. A packaged integrated circuit component comprises one or more integrated circuit dies mounted on a package substrate with the integrated circuit dies and package substrate encapsulated in a casing material, such as a metal, plastic, glass, or ceramic. In one example, a packaged integrated circuit component contains one or more processor units mounted on a substrate with an exterior surface of the substrate comprising a solder ball grid array (BGA). In one example of an unpackaged integrated circuit component, a single monolithic integrated circuit die comprises solder bumps attached to contacts on the die. The solder bumps allow the die to be directly attached to a printed circuit board. An integrated circuit component can comprise one or more of any computing system component described or referenced herein or any other computing system component, such as a processor unit (e.g., system-on-a-chip (SoC), processor core, graphics processor unit (GPU), accelerator, chipset processor), I/O controller, memory, or network interface controller.

As used herein, the phrase "electrically conductively coupled" refers to the presence of one or more electrically conductive paths between components that are recited as being conductively coupled. For example, with reference to FIG. 1, the shielding die 112 is electrically conductively coupled to the dies 106A-C due to the presence of electrically conductive paths through the package substrate 102 and the interposer 104 (e.g., through vias 111, 109, and 107).

As used in this application and the claims, a list of items joined by the term "and/or" can mean any combination of the listed items. For example, the phrase "A, B, and/or C" can mean A; B; C; A and B; A and C; B and C; or A, B and C. As used in this application and the claims, a list of items joined by the term "at least one of" can mean any combination of the listed terms. For example, the phrase "at least one of A, B, or C" can mean A; B; C; A and B; A and C; B and C; or A, B, and C. Moreover, as used in this application and the claims, a list of items joined by the term "one or more of" can mean any combination of the listed terms. For example, the phrase "one or more of A, B, and C" can mean A; B; C; A and B; A and C; B and C; or A, B, and C.

The disclosed methods, apparatuses, and systems are not to be construed as limiting in any way. Instead, the present disclosure is directed toward all novel and nonobvious features and aspects of the various disclosed embodiments, alone and in various combinations and subcombinations with one another. The disclosed methods, apparatuses, and systems are not limited to any specific aspect or feature or combination thereof, nor do the disclosed embodiments require that any one or more specific advantages be present or problems be solved.

Theories of operation, scientific principles, or other theoretical descriptions presented herein in reference to the apparatuses or methods of this disclosure have been provided for the purposes of better understanding and are not intended to be limiting in scope. The apparatuses and methods in the appended claims are not limited to those apparatuses and methods that function in the manner described by such theories of operation.

Although the operations of some of the disclosed methods are described in a particular, sequential order for convenient presentation, it is to be understood that this manner of description encompasses rearrangement, unless a particular ordering is required by specific language set forth herein. For example, operations described sequentially may in some cases be rearranged or performed concurrently. Moreover, for the sake of simplicity, the attached figures may not show the various ways in which the disclosed methods can be used in conjunction with other methods.

In the above description, specific details have been set forth, but embodiments of the technologies described may be practiced without each of these specific details. Well-known circuits, structures, and techniques have not been shown in detail to avoid obscuring an understanding of this description. Phrases such as "an embodiment," "various embodiments," "some embodiments," and the like may include features, structures, or characteristics, but not every embodiment necessarily includes the particular features, structures, or characteristics. Embodiments of the present disclosure may have some, all, or none of the features described in the examples described herein.

The following examples pertain to additional embodiments of technologies disclosed herein.

Example 1 is an apparatus comprising: a package substrate; a first integrated circuit die coupled to the package substrate; a second integrated circuit die coupled to the package substrate; and a die coupled to and covering the first integrated circuit die and the second integrated circuit die; wherein a functionality of the first integrated circuit die or a functionality of the second integrated circuit die is based on the first integrated circuit die and the second integrated circuit die being electrically conductively coupled with the die (e.g., the first integrated circuit die and the second integrated circuit die are electrically conductively coupled by at least one metal trace in the die covering the first integrated circuit die and the second integrated circuit die).

Example 2 includes the apparatus of Example 1, wherein the first integrated circuit die or the second integrated circuit die is to modify (e.g., disable) a functionality based on detecting that a circuit comprising the at least one metal trace is an open circuit.

Example 3 includes the apparatus of Example 1 or 2, wherein the first integrated circuit die or the second integrated circuit die is to delete certain data based on detecting that a circuit comprising the at least one metal trace is an open circuit.

Example 4 includes the apparatus of any one of Examples 1-3, wherein the first integrated circuit die is to transmit signals to the second integrated circuit die through the at least one metal trace, and the functionality of the second integrated circuit die is based on receiving the signals from the first integrated circuit die.

Example 5 includes the apparatus of Example 4, wherein the signals comprise a static value.

Example 6 includes the apparatus of Example 4, wherein the signals comprise an incrementing counter value.

Example 7 includes the apparatus of any one of Examples 1-3, wherein the first integrated circuit die or the second integrated circuit die is to obtain a value based on information stored in the at least one metal trace, and the functionality of the first integrated circuit die or the functionality of the second integrated circuit die is based on obtaining the value from the at least one metal trace.

Example 8 includes the apparatus of Example 7, wherein the value stored in the at least one metal trace comprises a package identifier.

Example 9 includes the apparatus of Example 7, wherein the value stored in the at least one metal trace comprises at least a portion of a cryptographic key or a cryptographic key share.

Example 10 includes the apparatus of any one of Examples 1-3, wherein the first integrated circuit die or the second integrated circuit die is to detect a change in one or more electrical properties of a circuit comprising the at least one metal trace, and the functionality of the first integrated circuit die or the functionality of the second integrated circuit die is to be modified based on detecting the change in the one or more electrical properties.

Example 11 includes the apparatus of any one of Examples 1-10, wherein the first integrated circuit die and the second integrated circuit die are to maintain certain functionalities based on detecting that a circuit comprising the at least one metal trace is an open circuit.

Example 12 includes the apparatus of any one of Examples 1-11, wherein the die extends beyond outer edges of the first integrated circuit die and the second integrated circuit die.

Example 13 includes the apparatus of any one of Examples 1-12, wherein the at least one metal trace substantially traverses a length of the die.

Example 14 includes the apparatus of any one of Examples 1-13, wherein the at least one metal trace is electrically conductively coupled to the first integrated circuit die or the second integrated circuit die through a side of the first integrated circuit die opposite the die or a side of the second integrated circuit die opposite the die.

Example 15 includes the apparatus of Example 14, wherein the at least one metal trace is electrically conductively coupled to the first integrated circuit die or the second integrated circuit die through metal traces in the package substrate.

Example 16 includes the apparatus of Example 14, wherein the at least one metal trace is electrically conductively coupled to the first integrated circuit die or the second integrated circuit die through metal traces in an interposer between the package substrate and the integrated circuit dies.

Example 17 includes the apparatus of any one of Examples 1-16, further comprising a layer comprising metal between the first integrated circuit die and the die or between the second integrated circuit die and the die.

Example 18 includes the apparatus of any one of Examples 1-17, further comprising an interposer surrounding the integrated circuit dies, the interposer comprising vias conductively coupling the at least one metal trace with the first integrated circuit die or the second integrated circuit die.

Example 19 includes the apparatus of any one of Examples 1-18, wherein the die does not include active circuit components.

Example 20 includes the apparatus of any one of Examples 1-19, further comprising a circuit board, the package substrate coupled to the circuit board.

Example 21 is a system comprising: an integrated circuit package comprising: a package substrate; a plurality of integrated circuit dies coupled to the package substrate; and a die covering the plurality of integrated circuit dies, the die comprising metal traces electrically conductively coupled to the plurality of integrated circuit dies; wherein a functionality of at least one integrated circuit die of the plurality of integrated circuit dies is based on being electrically conductively coupled with the metal traces of the die above the plurality of integrated circuit dies.

Example 22 includes the system of Example 21, wherein the functionality of the at least one integrated circuit die is to be modified based on detecting that a circuit comprising at least one metal trace of the die is an open circuit.

Example 23 includes the system of Example 21 or 22, wherein the at least one integrated circuit die is to delete certain data based on detecting that a circuit comprising at least one metal trace of the die is an open circuit.

Example 24 includes the system of any one of Examples 21-23, wherein a first integrated circuit die is to transmit signals to a second integrated circuit die through at least one metal trace of the die, and the functionality of the second integrated circuit die is based on receiving the signals from the first integrated circuit die.

Example 25 includes the system of Example 24, wherein the signals comprise a static value.

Example 26 includes the system of Example 24, wherein the signals comprise an incrementing counter value.

Example 27 includes the system of any one of Examples 21-23, wherein the at least one integrated circuit die is to obtain a value based on information stored in the metal traces of the die, and the functionality of the at least one integrated circuit die is based on obtaining the value.

Example 28 includes the system of Example 27, wherein the value stored in the metal traces of the die comprises a package identifier.

Example 29 includes the system of Example 27, wherein the value stored in the metal traces of the die comprises at least a portion of a cryptographic key or a cryptographic key share.

Example 30 includes the system of any one of Examples 21-23, wherein the at least one integrated circuit die is to detect a change in one or more electrical properties of a circuit comprising a metal trace of the die, and the functionality of the at least one integrated circuit die is to be modified based on detecting the change in the one or more electrical properties.

Example 31 includes the system of any one of Examples 21-30, wherein the at least one integrated circuit die is to maintain certain functionalities based on detecting that a circuit comprising a metal trace of the die is an open circuit.

Example 32 includes the system of any one of Examples 21-31, wherein the die extends beyond outer edges of each integrated circuit die of the plurality of integrated circuit dies.

Example 33 includes the system of any one of Examples 21-32, wherein the metal traces of the die substantially traverse a length of the die.

Example 34 includes the system of any one of Examples 21-33, wherein the metal traces of the die are electrically conductively coupled to the integrated circuit dies on a side opposite the die.

Example 35 includes the system of Example 34, wherein the metal traces of the die are electrically conductively coupled to the integrated circuit dies through the package substrate.

Example 36 includes the system of Example 34, wherein the metal traces of the die are electrically conductively coupled to the integrated circuit dies through an interposer between the package substrate and the integrated circuit dies.

Example 37 includes the system of any one of Examples 21-36, wherein the integrated circuit package further comprises a layer comprising metal between the die and at least one integrated circuit die.

Example 38 includes the system of any one of Examples 21-37, wherein the integrated circuit package further comprises an interposer surrounding the plurality of integrated circuit dies, the interposer comprising vias conductively coupling at least one metal trace of the die with an integrated circuit die of the plurality of integrated circuit dies.

Example 39 includes the system of any one of Examples 21-38, wherein the die does not include active circuit components.

Example 40 includes the system of any one of Examples 21-32, further comprising a circuit board, the integrated circuit package coupled to the circuit board.

Example 41 includes the system of Example 40, further comprising power delivery circuitry coupled to the circuit board, the power delivery circuitry coupled to at least one integrated circuit die through one or more metal traces of the die.

Example 42 is an integrated circuit device assembly comprising: a circuit board; an interposer coupled to the circuit board; a plurality of integrated circuit components coupled to the interposer; a die coupled to and physically shielding the plurality of integrated circuit components, the die covering each of the plurality of integrated circuit components and comprising metal traces interconnecting a first integrated circuit component of the plurality of integrated circuit components with a second integrated circuit component of the plurality of integrated circuit components.

Example 43 includes the integrated circuit device assembly of Example 42, wherein a functionality of the first integrated circuit component or a functionality of the second integrated circuit component is based on the metal traces being electrically conductively coupled between the first integrated circuit component and the second integrated circuit component.

Example 44 includes the integrated circuit device assembly of Example 42 or 43, wherein the first integrated circuit component or the second integrated circuit component is to delete data based on detecting that a circuit comprising a metal trace of the die is an open circuit.

Example 45 includes the integrated circuit device assembly of any one of Examples 42-44, wherein the first integrated circuit component is to transmit signals to the second integrated circuit component through the metal traces, and a functionality of the second integrated circuit component is based on receiving the signals from the first integrated circuit component.

Example 46 includes the integrated circuit device assembly of Example 45, wherein the signals comprise a static value.

Example 47 includes the integrated circuit device assembly of Example 45, wherein the signals comprise an incrementing counter value.

Example 48 includes the integrated circuit device assembly of any one of Examples 42-44, wherein the first integrated circuit component or the second integrated circuit component is to obtain a value based on information stored in the metal traces of the die, and a functionality of the first integrated circuit component or the functionality of the second integrated circuit component is based on obtaining the value from the metal traces.

Example 49 includes the integrated circuit device assembly of Example 48, wherein the value stored in the metal traces comprises a package identifier.

Example 50 includes the integrated circuit device assembly of Example 48, wherein the value stored in the metal traces comprises at least a portion of a cryptographic key or a cryptographic key share.

Example 51 includes the integrated circuit device assembly of any one of Examples 42-44, wherein the first integrated circuit component or the second integrated circuit component is to detect a change in one or more electrical properties of a circuit comprising the metal traces, and a functionality of the first integrated circuit component or a functionality of the second integrated circuit component is to be modified based on detecting the change in the one or more electrical properties.

Example 52 includes the integrated circuit device assembly of any one of Examples 42-51, wherein the first integrated circuit component and the second integrated circuit component are to maintain certain functionalities based on detecting that a circuit comprising the metal traces is an open circuit.

Example 53 is a system comprising: a circuit board; and an integrated circuit package coupled to the circuit board, the integrated circuit package comprising: a package substrate; a plurality of integrated circuit dies coupled to the package substrate; and a die covering the plurality of integrated circuit dies, the die comprising metal traces electrically conductively coupled to the plurality of integrated circuit dies; wherein at least one integrated circuit die of the plurality of integrated circuit dies is electrically conductively coupled with the metal traces of the die above the plurality of integrated circuit dies.

Example 54 includes the system of Example 53, wherein the functionality of the at least one integrated circuit die is to be modified based on detecting that a circuit comprising at least one metal trace of the die is an open circuit.

Example 55 includes the system of Example 53 or 54, wherein the at least one integrated circuit die is to delete certain data based on detecting that a circuit comprising at least one metal trace of the die is an open circuit.

Example 56 includes the system of any one of Examples 53-55, wherein a first integrated circuit die is to transmit signals to a second integrated circuit die through at least one metal trace of the die, and the functionality of the second integrated circuit die is based on receiving the signals from the first integrated circuit die.

Example 57 includes the system of any one of Examples 53-55, wherein the at least one integrated circuit die is to obtain a value based on information stored in the metal traces of the die, and the functionality of the at least one integrated circuit die is based on obtaining the value.

## Claims

1. An apparatus comprising:
a package substrate;
a first integrated circuit die coupled to the package substrate;
a second integrated circuit die coupled to the package substrate; and
a die coupled to and covering the first integrated circuit die and the second integrated circuit die;
wherein a functionality of the first integrated circuit die or a functionality of the second integrated circuit die is based on the first integrated circuit die and the second integrated circuit die being electrically conductively coupled with the die.

2. The apparatus of claim 1, wherein the first integrated circuit die and the second integrated circuit die are electrically conductively coupled by a metal trace in the die covering the first integrated circuit die and the second integrated circuit die.

3. The apparatus of claim 1 or 2, wherein the first integrated circuit die or the second integrated circuit die is to modify a functionality based on detecting that a circuit comprising a metal trace of the die is an open circuit.

4. The apparatus of any one of claims 1-3, wherein the first integrated circuit die or the second integrated circuit die is to delete certain data based on detecting that a circuit comprising a metal trace of the die is an open circuit.

5. The apparatus of any one of claims 1-4, wherein the first integrated circuit die is to transmit signals to the second integrated circuit die through at least one metal trace of the die, and the functionality of the second integrated circuit die is based on receiving the signals from the first integrated circuit die.

6. The apparatus of claim 5, wherein the signals comprise a static value or an incrementing counter value.

7. The apparatus of any one of claims 1-6, wherein the first integrated circuit die or the second integrated circuit die is to obtain a value based on information stored in the die, and the functionality of the first integrated circuit die or the functionality of the second integrated circuit die is based on obtaining the value from the die.

8. The apparatus of claim 7, wherein the value stored in the die comprises a package identifier, at least a portion of a cryptographic key, or a cryptographic key share.

9. The apparatus of any one of claims 1-8, wherein the first integrated circuit die or the second integrated circuit die is to detect a change in one or more electrical properties of a circuit comprising a metal trace of the die, and the functionality of the first integrated circuit die or the functionality of the second integrated circuit die is to be modified based on detecting the change in the one or more electrical properties.

10. The apparatus of any one of claims 1-9, wherein the first integrated circuit die and the second integrated circuit die are to maintain certain functionalities based on detecting that a circuit comprising a metal trace of the die is an open circuit.

11. The apparatus of any one of claims 1-10, further comprising a layer comprising metal between the first integrated circuit die and the die or between the second integrated circuit die and the die.

12. The apparatus of any one of claims 1-11, further comprising an interposer surrounding the first integrated circuit die and the second integrated circuit die, the interposer comprising vias conductively coupling metal traces of the die with the first integrated circuit die or the second integrated circuit die.

13. A system comprising:
a circuit board; and
an integrated circuit package coupled to the circuit board, the integrated circuit package comprising the apparatus of any one of claims 1-12.

14. An integrated circuit device assembly comprising:
a circuit board;
an interposer coupled to the circuit board;
a plurality of integrated circuit components coupled to the interposer;
a die coupled to and physically shielding the plurality of integrated circuit components, the die covering each of the plurality of integrated circuit components and comprising metal traces interconnecting a first integrated circuit component of the plurality of integrated circuit components with a second integrated circuit component of the plurality of integrated circuit components.

15. The integrated circuit device assembly of claim 14, wherein a functionality of the first integrated circuit component or a functionality of the second integrated circuit component is based on the metal traces being electrically conductively coupled between the first integrated circuit component and the second integrated circuit component.
